**Europäisches Patentamt**

**European Patent Office**

**Office européen des brevets**

(11) Veröffentlichungsnummer: **0 438 727 A2**

## (12) EUROPÄISCHE PATENTANMELDUNG

(21) Anmeldenummer: 90124494.7

(22) Anmeldetag: 18.12.90

(51) Int. Cl.5: **H01L 21/306**

(30) Priorität: 26.01.90 DE 4002327

(43) Veröffentlichungstag der Anmeldung:
**31.07.91 Patentblatt 91/31**

(84) Benannte Vertragsstaaten:
**DE GB IT**

(71) Anmelder: **Wacker-Chemitronic Gesellschaft
für Elektronik-Grundstoffe mbH
Johannes-Hess-Strasse 24
W-8263 Burghausen(DE)**

(72) Erfinder: **Schnegg, Anton, Dr. Dipl.-Chem.
Robert-Koch-Strasse 175
W-8263 Burghausen(DE)**
Erfinder: **Nussstein, Peter, Dr. Dipl.-Chem.
Ehrenbreitsteiner Strasse 47
W-8000 München 50(DE)**
Erfinder: **Fabry, Laszlo, Dr. Dipl.-Chem.
Mühlbachstrasse 72
W-8261 Emmerting(DE)**
Erfinder: **Valouch, Gertrud
Böcklerstrasse 15
W-8263 Burghausen(DE)**

(54) **Verfahren zur Nasschemischen Behandlung von Halbleiteroberflächen und Lösung zu seiner Durchführung.**

(57) Bei der Behandlung von Halbleiter-, insbesondere Siliciumscheiben mit wäßrigen flußsäurehaltigen Lösungen wird in der Regel eine Kontamination der Scheibenoberfläche mit die nachfolgenden Prozesse störenden Partikeln beobachtet. Diese Partikelzunahme kann dadurch deutlich verringert werden, daß den Lösungen zusätzlich zur Bildung von Einschlußverbindungen befähigte organische Ringmoleküle, wie etwa Cyclodextrine, und/oder Säuren mit $pK_s$-Wert unterhalb 3.14, die das Halbleitermaterial nicht zu oxidieren vermögen, beigemischt werden. Die eigentliche Behandlung kann in der üblichen Weise z.B. in Tauchbädern durchgeführt werden.

EP 0 438 727 A2

EP 0 438 727 A2

## VERFAHREN ZUR NASSCHEMISCHEN BEHANDLUNG VON HALBLEITEROBERFLÄCHEN UND LÖSUNG ZU SEINER DURCHFÜHRUNG.

Die Erfindung betrifft ein Verfahren zur naßchemischen Behandlung von Halbleiteroberflächen durch Einwirkung von flußsäurehaltigen wäßrigen Lösungen, sowie Lösungen zu seiner Durchführung.

Viele Prozesse der Halbleitertechnologie, bei denen die Scheibenoberfläche einer naßchemischen Behandlung unterzogen wird, beinhalten einen Teilschritt, in dem eine bereits vorhandene oder gebildete oberflächige Oxidschicht von der Scheibenoberfläche ganz oder teilweise wieder entfernt wird. Besondere Bedeutung haben solche Teilschritte in der Siliciumtechnologie, wo z.B. bei Reinigungs- oder photolithographischen Prozessen, ebenso wie bei Temper- oder Getterprozessen das Erzeugen und anschließende Entfernen oberflächiger Oxidschichten, oft auch mehrfach hintereinander, Standardarbeitsgänge sind. Beispielhaft sei auf das von W. Kern und D. Puotinen in RCA Review, June 1970, Seite 187 bis 206 beschriebene Reinigungsverfahren (in der Fachsprache oft als "RCA-Reinigung" bezeichnet) verwiesen. Dort ist eine Abfolge von naßchemischen Oxidations- und Abtragsschritten beschrieben, die dazu dient, die Oberflächen von Siliciumscheiben nach dem chemomechanischen Polieren in einen für die Bauelementherstellung geeigneten Zustand überzuführen, in dem sie also nicht nur eine ausgezeichnete geometrische Qualität aufweisen, sondern auch ein Höchstmaß an chemischer Reinheit besitzen und frei von Partikeln sind.

In nahezu allen Fällen wird die teilweise oder vollständige Ablösung der jeweils vorliegenden Oxidschichten mit Hilfe von Flußsäure durchgeführt, wobei diese im allgemeinen entweder in wäßriger Lösung in einem Tauchbad mit dem Oxid in Reaktion tritt, oder aber über die Dampfphase. Die in wäßriger Form eingesetzten Flußsäurelösungen besitzen dabei gegenüber denjenigen in Dampfform erfahrungsgemäß zusätzlich eine deutlich bessere Reinigungswirkung im Hinblick auf die Scheibenoberfläche kontaminierende Schwermetalle, insbesondere Eisen.

Die Behandlung mit Flußsäure in wäßriger Form hat jedoch einen schwerwiegenden Nachteil: In ihrem Verlauf erhöht sich nämlich in der Regel die Anzahl der Partikel auf der Scheibenoberfläche deutlich, so daß meist ein weiterer Behandlungsschritt durchgeführt werden muß, um die Partikelzahl auf ein für die Weiterverarbeitung der Scheiben geeignetes Maß zurückzuführen. Die Partikel bestehen im allgemeinen aus in der Lösung enthaltener Polykieselsäure und organischen Stoffen; ihre Zunahme kann beispielsweise bei Siliciumscheiben mit einem Durchmesser von ca. 10 cm durchaus, bezogen auf die meßtechnisch besonders gut erfaßbaren Partikel im Größenbereich von 0.17 bis 1 $\mu$m, 5000 Partikel betragen. Die Partikelzahl kann beispielsweise mit Hilfe von Streulicht-Meßmethoden festgestellt werden. Dabei wird die Scheibenoberfläche beispielsweise mit Laserlicht bestrahlt und die Intensität des von ihr ausgehenden gestreuten Lichtes gemessen, welche mit der Partikelzahl korreliert werden kann.

Besonders hoch ist die Partikelzahl, wenn die Scheibe aus einem Flußsäurelösung enthaltenden Bad herausgehoben wird oder wenn auf die frisch mit Flußsäure behandelte, nasse Scheibenoberfläche der Einwirkung von Sauerstoff ausgesetzt ist, wie es beispielsweise auch bei heftig umgewälzten Flußsäurebädern der Fall ist. Ungünstigerweise nimmt bei anschließenden oxidativen Reinigungsschritten in alkalischem oder saurem wäßrigem Medium die Partikelzahl noch weiter zu.

Bisher wird versucht, diesem Problem durch Herausverdünnen der Flußsäurelösung zu begegnen, d.h. indem eine größere Menge Reinstwasser zugeführt und somit die in der Volumeneinheit der flußsäurehaltigen wäßrigen Phase vorhandene Partikelzahl verringert wird. Die bei dieser Methode verbrauchten Reinstwassermengen sind jedoch beträchtlich. Wird hingegen, gemäß einer anderen bekannten Vorgehensweise, die Flußsäurelösung in stark verdünnter Form eingesetzt, verlängert sich dadurch die erforderliche Einwirkungsdauer in solchem Maße, daß eine zügige und wirtschaftlich vertretbare Prozeßführung nicht mehr gewährleistet ist. Dies gilt auch für Verfahrensvarianten, in denen die Lösung blasenfrei umgewälzt und dabei einer Filtration unterzogen wird.

Die bei allen derartigen Verfahren erzeugten Oberflächen enthalten jedoch immer noch Keime für weiteres Partikelwachstum, so daß in der Regel bei nachfolgenden alkalischen oder sauren oxidativen Behandlungsschritten erneut eine deutliche Erhöhung der Partikelzahlen auf der vorher einwandfrei erscheinenden Scheibenoberfläche festzustellen ist.

Die Aufgabe der Erfindung lag also darin, ein einfaches Verfahren anzugeben, das die Behandlung von Halbleiter-, insbesondere Siliciumscheiben mit flußsäurehaltigen wäßrigen Lösungen gestattet, ohne mit einer wesentlichen Zunahme der Anzahl der auf der Scheibenoberfläche vorhandenen Partikel verbunden zu sein.

Gelöst wird die Aufgabe durch ein Verfahren, welches dadurch gekennzeichnet ist, daß die eingesetzten Lösungen als zusätzliche Komponenten

2

a) zur Bildung von Einschlußverbindungen befähigte, Ringmoleküle bildende organische Verbindungen

b) das zu behandelnde Halbleitermaterial nicht oxidierende, einen $pK_s$-Wert von weniger als 3.14 aufweisende Säuren,

einzeln oder in Kombination enthalten.

Überraschend wurde gefunden, daß sich mit diesem Verfahren die im Anschluß an die Flußsäurebehandlung festzustellenden Partikelzahlen auf Halbleiteroberflächen deutlich verringern lassen. Besonders bemerkenswert ist die Tatsache, daß auch bei nachfolgenden alkalischen oder sauren oxidativen Behandlungsschritten keine Zunahme, sondern eine weitere Abnahme der Partikelzahlen zu beobachten ist.

Als zur Bildung von Einschlußverbindungen befähigte, Ringmoleküle bildende organische Verbindungen werden mit besonderem Vorteil Cyclodextrine eingesetzt, also Verbindungen aus miteinander verknüpften Glucoseringen, wie sie beispielsweise beim biologischen Abbau von Stärke durch Bacillus macerans gebildet werden. Als geeignet haben sich dabei sowohl die aus sechs Glucoseringen bestehenden $\alpha$-Cyclodextrine, die aus 7 Glucoseringen bestehenden $\beta$-Cyclodextrine, wie auch die aus 8 Glucoseringen bestehenden $\gamma$-Cyclodextrine erwiesen. Bewährt haben sich vor allem die Hydroxypropyl-Derivate dieser Cyclodextrine, insbesondere das Hydroxypropyl-$\alpha$-cyclodextrin, obwohl sich grundsätzlich auch die entsprechenden Methyl-, Ethyl-, Isopropyl- oder Butyl- bzw. Isobutyl-Hydroxyderivate einsetzen lassen. Dabei können sowohl Mischungen verschiedener Cyclodextrine, als auch nur jeweils bestimmte Cyclodextrinderivate einzeln für sich als zusätzliche Komponente a) verwendet werden. Vorteilhaft werden Cyclodextrine eingesetzt, deren molarer Substitutionsgrad (MS) im Bereich von 0.5 bis 3, bevorzugt bei 0.5 bis 1 liegt. Aus diesem MS-Wert läßt sich abschätzen, zu welchem Anteil bei dem jeweiligen, in der Regel als Gemisch verschieden stark substituierter Verbindungen vorliegenden Cyclodextrin die verfügbaren OH-Gruppen substituiert sind.

Neben den bevorzugt verwendeten Cyclodextrinen eignen sich auch andere Ringmoleküle bildende organische Verbindungen wie etwa Kronenether zur Verwendung als Komponente a). Beispiele für geeignete Kronenether sind solche, die eine ausreichende Ringgröße aufweisen, wie etwa die mit 15-Krone-5, 18-Krone-6 oder 24-Krone-8 bezeichneten Ringgrundgerüste, die vorzugsweise mit hydrophilierenden Substituenten wie etwa OH-, $OCH_3$- oder COOH-Gruppen derivatisiert sind.

Vorteilhaft werden bei der Bereitstellung der schließlich auf die Halbleiteroberflächen einwirkenden Mischung die als Komponente a) vorgesehenen Cyclodextrine in wäßriger Lösung mit der flußsäurehaltigen Ausgangslösung gemischt, wobei sich für die fertige wäßrige Zusatzlösung Cyclodextrinanteile von etwa 0.01 bis 10 Gew.% als gut geeignet erwiesen haben. Grundsätzlich können jedoch die Cyclodextrine auch in ungelöster Form oder in stärker konzentrierten Lösungen zugefügt werden. Auch die Kronenether lassen sich günstig in gelöster Form zumischen.

Als Grundlösungen kommen die in der Halbleitertechnologie gebräuchlichen flußsäurehaltigen Lösungen in Frage, sowohl was die Konzentrationen als auch die erforderliche Freiheit von chemischen Verunreinigungen als auch von Partikeln anbelangt. Der Flußsäuregehalt wird jeweils nach Maßgabe der vorgesehenen Anwendung eingestellt und liegt bei der fertig gemischten, auf die Halbleiteroberfläche einwirkenden Lösung in den meisten Fällen unterhalb etwa 40 Gew.%, vorzugsweise unterhalb etwa 10 Gew.%, wobei im Bereich von etwa 0.08 bis 6 Gew.% besonders gute Ergebnisse erzielt wurden. Günstig lassen sich die gewünschten Konzentrationen durch Verdünnen von konzentrierteren Flußsäurelösungen einstellen, die in den den Anforderungen bezüglich Reinheit und Partikelzahl entsprechenden Spezifikationen beispielsweise im Handel erhältlich sind. Es sind jedoch auch Verfahrensvarianten möglich, bei denen einer vorgelegten flußsäurefreien oder flußsäurearmen, die sonstigen Komponenten bereits enthaltenden wässrigen Lösung der noch benötigte Fluorwasserstoff in Gasform zugeführt wird. Eine solche Vorgehensweise hat sich insbesondere bei Verfahren bewährt, bei denen die Halbleiteroberflächen mit der Lösung besprüht werden und die endgültig einwirkende Zusammensetzung sich erst unmittelbar auf diesen durch Zusammenwirken von flüssiger und Gasphase bildet. Hierzu sei beispielsweise auf das in der DE-A-38 18 714 bzw. der entsprechenden US-Anmeldung mit Aktenzeichen 359,508 beschriebene Verfahren verwiesen.

Eine weitere Möglichkeit zur Verringerung der Partikelzahl bei der Behandlung von Halbleiteroberflächen mit flußsäurehaltigen wäßrigen Lösungen besteht darin, diesen alternativ oder zusätzlich zu den oben beschriebenen Komponenten a) das zu behandelnde Halbleitermaterial nicht oxidierende, einen pKs-Wert von weniger als 3.14 aufweisende Säuren als Komponente b) zuzusetzen, wobei grundsätzlich anorganische und/oder organische Säuren Verwendung finden können. Überraschenderweise wurde nämlich gefunden, daß bei Zusatz der Komponente b) sowohl einzeln für sich als auch insbesondere in Kombination mit der Komponente a) auf den mit solcherart zusammengesetzten wäßrigen Flußsäurelösungen behandelten Halbleiteroberflächen deutlich geringere Partikelzahlen festzustellen sind, als wenn die Behandlung mit derartige Zusätze nicht enthaltenden wäßrigen Flußsäurelösungen durchgeführt wird.

Als anorganische Säuren kommen in erster Linie die Halogenwasserstoffsäuren HBr, HJ oder insbesondere HCl in Frage, da bei ihnen ein oxidativer Angriff auf das Halbleitermaterial nicht möglich ist. Weiterhin eignen sich auch sauerstoffhaltige Säuren mit entsprechend niedrigen $pK_s$-Werten, die das zu behandelnde Halbleitermaterial nicht zu oxidieren vermögen, wie im Falle des Siliciums oder Germaniums beispielsweise die Schwefel- oder die Perchlorsäure, deren $pK_s$-Wert bei ca. -3 bzw. -9 liegt. Erfahrungsgemäß werden mit Säuren mit negativem $pK_s$-Wert, also größerer Säurestärke, bessere Ergebnisse erzielt als mit demgegenüber schwächeren Säuren wie etwa der Phosphorsäure, deren $pK_s$-Wert in der ersten Dissoziationsstufe bei 1.96 liegt.

Geeignete organische Säuren sind beispielsweise entsprechend niedrige $pK_s$-Werte aufweisende, stark saure Carbonsäuren wie etwa Mono-, Di- oder Trichloressigsäure oder Trifluoressigsäure. Diese Säuren haben zusätzlich den Vorteil der bakteriziden Wirkung. Weitere geeignete Säuren sind beispielsweise manche Sulfonsäuren, d.h. organische Derivate der Schwefelsäure.

Günstige Konzentrationen der Komponente b) liegen im Bereich bis ca. 2 Gew.%, bezogen auf die Gesamtlösung, wobei besonders gute Ergebnisse mit Anteilen von 0.5 bis 1 Gew.% zu erzielen sind. Grundsätzlich sind jedoch auch höhere Anteile der als Komponente b) ausgewählten Säure bis zu etwa 5 Gew.% möglich, ebenso der Einsatz von Säuremischungen.

In einfacher Weise lassen sich die gewünschten Konzentrationen durch Verdünnen von stärker konzentrierten Ausgangsverbindungen einstellen, wofür beispielsweise die in den außerordentlich hohen Reinheitsanforderungen der Halbleiterindustrie entsprechender Qualität im Handel erhältliche, üblicherweise maximal 50 gew.%ige konzentrierte Flußsäure oder die ca. 37 gew.%ige konzentrierte Salzsäure geeignet sind. Selbstverständlich ist zur Verdünnung Wasser in entsprechender Reinheit und Partikelfreiheit erforderlich. Weiterhin ist es nicht ausgeschlossen, die benötigte Säure durch Zufuhr von gasförmigen Komponenten, wie etwa gasförmigem Chlorwasserstoff, oder durch Zugabe von Säureanhydriden wie etwa Phosphorpentoxid in die wäßrige Phase auf die gewünschte Zusammensetzung zu bringen.

Insbesondere für die Behandlung von mit Oxidschichten versehenen Siliciumscheiben haben sich wäßrige flußsäurehaltige Lösungen bewährt, die 0.08 bis 6 Gew.% Fluorwasserstoff, und mindestens eine der Komponenten a) und b), und zwar bis 2 Gew.% Chlorwasserstoff als Komponente b) und bis 0.1 Gew% Cyclodextrin als Komponente a) enthalten. Besonders gute Ergebnisse hinsichtlich der Partikelfreiheit der behandelten Scheiben sowohl nach der Flußsäureeinwirkung als auch nach anschließenden alkalischen oder sauren oxidativen Prozeßschritten können mit Lösungen erzielt werden, die 0.8 bis 1.2 Gew.% Fluorwasserstoff, 0.7 bis 1.1 Gew.% Chlorwasserstoff, und 0.01 bis 0.03 Gew.% Hydroxyalkyl-α-Cyclodextrin, insbesondere Hydroxypropyl-α-Cyclodextrin enthalten. Vorteilhaft liegt der molare Substitutionsgrad der Cyclodextrine bei 0.5 bis 1.

Die jeweils ausgewählte wäßrige flußsäurehaltige Lösung kann mit Hilfe der bekannten Methoden zur Einwirkung auf die zu behandelnden Halbleiteroberflächen gebracht werden. Dies kann beispielsweise in Tauchbädern geschehen, welche gegebenenfalls auf bestimmte Temperaturen eingestellt sind und in welche die in der Regel als Scheiben vorliegenden Halbleiter einzeln oder zu Prozeßhorden zusammengefaßt eingetaucht, für die jeweils gewünschte Einwirkungsdauer belassen und danach wieder entnommen werden. Vorteilhaft wird dabei die Badflüssigkeit umgewälzt und/oder die Scheiben im Bad einer langsamen Bewegung unterworfen, um eine besonders effektive Einwirkung zu erzielen. Eine andere Einwirkungsmöglichkeit besteht darin, die Lösung auf die Scheibenoberfläche aufzusprühen oder aufzuschleudern, was zweckmäßig in entsprechend ausgerüsteten Behandlungskammern wie etwa Sprüh- oder Schleuderätzern vorgenommen wird.

Danach können in der üblichen Art die nachfolgenden Behandlungsschritte wie Hydrophilierung, naßchemische oder thermische Oxidation, Trocknung, Bestrahlung oder Abscheidungsvorgänge angeschlossen werden. Wie bereits weiter oben ausgeführt, verringern sich bei solcherart vorbehandelten Scheiben bei nachfolgenden alkalischen oder sauren oxidativen Prozessen die Partikelzahlen, während bei den konventionell sauer oxidativ vorbehandelten Scheiben gewöhnlich eine erhebliche Zunahme eintritt.

Eine weitere Verbesserung der Ergebnisse kann dadurch erreicht werden, daß im Anschluß an die Behandlung mit wäßriger, zusätzlich die Komponenten a) und/oder b) enthaltender Flußsäurelösung die Scheiben, zweckmäßig nach einem Spül- und Trockenschritt, kurzzeitig mit ultraviolettem Licht bestrahlt werden. Dabei haben sich Bestrahlungszeiten von 0.5 bis 10 Minuten als günstig erwiesen. Die Bestrahlung kann mittels geeigneter flächendeckender Strahlungsquellen, beispielsweise mittels Niederdruck-Quecksilberlampen vorgenommen werden, bei denen die bestrahlte Fläche groß genug ist, um eine gleichmäßige Bestrahlung der Scheibenoberfläche zu gewährleisten. Geeignete Wellenlängen liegen beispielsweise für Silicium im Bereich von 180 bis 500 nm. Derart nachbehandelte Scheiben zeichnen sich im allgemeinen durch besonders niedrige Partikelzahlen aus.

Das erfindungsgemäße Verfahren eignet sich allgemein für die Behandlung von Scheiben aus solchen Halbleitermaterialien, die Oxidschichten ausbilden, welche von Flußsäure angegriffen werden. Mit besonde-

EP 0 438 727 A2

rem Vorteil wird es zur Behandlung von Siliciumscheiben eingesetzt, und zwar vor allem bei der Reinigung von schleierfrei polierten Scheiben vor dem Verpacken, der Reinigung von Scheiben vor der sog. LTCVD-Beschichtung (Niedertemperaturgasphasenabscheidung z.B. von polykristallinem oder oxidischem Material), und beim Abätzen von thermisch oxidierten Siliciumoberflächen. Andere Einsatzmöglichkeiten liegen bei der Behandlung von anderen Elementhalbleitern wie Germanium, oder von Verbindungshalbleitern wie Galliumarsenid, Indiumphosphid oder Galliumphosphid.

Nachstehend wird das Verfahren an Hand von Ausführungsbeispielen näher erläutert:

Beispiel 1:

Als zu behandelnde Substrate waren jeweils Gruppen von 5 schleierfrei polierten Siliciumscheiben (Scheibendurchmesser ca. 20 cm, (111)-Orientierung, spez. Widerstand ca. 5 - 50 $\Omega$cm) vorgesehen, die einer hydrophilen Reinigung durch Eintauchen in ein Ammoniak/$H_2O_2$-Bad unterzogen worden waren, so daß ihre Oberfläche von einer dünnen Oxidhaut überzogen war. Die Scheiben wurden in Prozeßhorden aus Polytetrafluorethylen (PTFE) eingesetzt und für 2 Minuten in ein Tauchbad, einen etwa 6 Liter Flüssigkeit fassenden Behälter aus Polytetrafluorethylen, eingetaucht. Dieser war jeweils mit einer flußsäurehaltigen wässrigen Lösung beschickt, der in der nachstehend angegebenen Weise Komponenten a) und/oder b) beigemischt waren. Während der Tauchzeit wurden die Horden langsam in der Badflüssigkeit hin- und herbewegt, so daß eine gute Zu- bzw. Abführung unverbrauchter bzw. verbrauchter Lösung gewährleistet war. Die Badtemperatur war auf ca. 25° C eingestellt.

Die bei den unterschiedlichen Behandlungen eingesetzten Lösungen wurden durch Verdünnen von konzentrierten, entsprechend zusammengesetzten Ausgangsmischungen mittels Reinstwasser auf jeweils 6 Liter hergestellt. Die Ausgangsmischungen wurden durch Verrühren von entsprechenden Anteilen von 50 gew.%iger wässriger Flußsäure, 2 gew.%iger wässriger Hydroxypropyl-$\alpha$-Cyclodextrinlösung (MS 0.6) und 34 gew.%iger wässriger Salzsäure zubereitet.

Nach Ablauf der vorgesehenen Behandlungszeit wurde die Lösung rasch aus dem Tauchbad abgezogen, und die Scheiben wurden trockengeschleudert. Ein Teil der Scheiben wurde dann noch einer 2-minütigen Bestrahlung unter einer UV-Lampe (Wellenlänge 254 nm, Niederdruck-Quecksilber-Ausführung, spiralige Anordnung des Strahlers, Spiralendurchmesser gleich Scheibendurchmesser) unterzogen.

Ein Teil der unbestrahlten und der bestrahlten Scheiben wurde weiterhin noch einer 10-minütigen alkalischen oxidativen Tauchbehandlung in wäßriger ammoniakalischer Wasserstoffperoxid-Lösung bei ca. 60° C unterzogen, gespült und danach trockengeschleudert.

Zu Vergleichszwecken wurden weitere Scheibengruppen analogen Behandlungsschritten unterzogen, wobei allerdings die Behandlung mit wässriger flußsäurehaltiger Lösung ohne Zusatz der Komponenten a) und/oder b) vorgenommen wurde.

Jede Scheibe wurde vor Beginn und nach Abschluß der vorgesehenen Behandlungsabfolge zur Ermittlung der Anzahl der auf der polierten Oberfläche vorhandenen Partikel in einem handelsüblichen Partikelmeßgerät untersucht. Bei der Messung wurde ein Laserstrahl auf die Scheibenoberfläche gerichtet und die Intensität des von ihr ausgehenden diffusen Streulichtes gemessen. Aus dieser kann auf die Anzahl der auf der Oberfläche vorhandenen Partikel geschlossen werden, da diese als Streuzentren für das eingestrahlte Licht wirken und somit die Steulichtintensität mit wachsender Partikelzahl zunimmt. Eine andere mögliche Meßmethode besteht darin, die als Lichtpunkte im Mikroskop sichtbaren Partikel auszuzählen.

Die erhaltenen Ergebnisse sind in der Tabelle zusammengestellt. Sie zeigen, daß nach dem erfindungsgemäßen Verfahren behandelte Siliciumscheiben sich durch deutlich bessere Partikelwerte als in konventioneller Weise zusatzfrei behandelte Siliciumscheiben auszeichnen. Dies gilt sowohl für die unmittelbar nach der Flußsäurebehandlung, als auch für die nach der UV-Bestrahlung sowie nach der alkalischen oxidativen Behandlung untersuchten Scheibenoberflächen, bei denen bemerkenswerterweise eine weitere Abnahme der Partikelzahlen festzustellen ist.

5

Tabelle: Partikelzahl schleierfrei polierter Siliciumscheiben nach Behandlung mit HF-Lösung verschiedener Zusammensetzung, sowie ggf. Nachbehandlung durch UV-Bestrahlung und/oder Ammoniak/Wasserstoffperoxid-Lösung

| HF-Lösung, Zusammensetzung | | | UV-Bestrahlung | $NH_3/H_2O_2$ Bad | Anzahl Partikel auf der Oberfläche |
| HF (Gew.-%) | HCl (Gew.%) | Cyclodex. (Gew.-%) | (+ = durchgeführt − = nicht durchg.) | | (0.17 − 1 $\mu$m Partikelgr.) |
|---|---|---|---|---|---|
| 1.0 | 0 | 0 | − | − | 4098 |
| 1.0 | 0.9 | 0 | − | − | 1755 |
| 1.0 | 0 | 0.02 | − | − | 328 |
| 1.0 | 0.9 | 0.02 | − | − | 228 |
| 1.0 | 0 | 0 | + | − | 1086 |
| 1.0 | 0.9 | 0 | + | − | 302 |
| 1.0 | 0 | 0.02 | + | − | 288 |
| 1.0 | 0.9 | 0.02 | + | − | 50 |
| 1.0 | 0 | 0 | − | + | 915 |
| 1.0 | 0.9 | 0 | − | + | 236 |
| 1.0 | 0 | 0.02 | − | + | 212 |
| 1.0 | 0.9 | 0.02 | − | + | 249 |
| 1.0 | 0 | 0 | + | + | 870 |
| 1.0 | 0.9 | 0 | + | + | 217 |
| 1.0 | 0 | 0.02 | + | + | 68 |
| 1.0 | 0.9 | 0.02 | + | + | 36 |

Beispiel 2:

In der in Beispiel 1 beschriebenen Weise wurden Gruppen von 5 schleierfrei polierten Siliciumscheiben der selben Spezifikation einer Behandlung mit wäßriger flußsäurehaltiger Lösung unterzogen, mit dem Unterschied, daß der Lösung als Komponente a) ein Anteil von 0.02 Gew.%, bezogen auf die Gesamtlösung, eines Kronenethers zugesetzt war. Da eine ausreichende Löslichkeit in der wässrigen Phase gegeben war, konnten die Kronenether in unsubstituierter Form eingesetzt werden. Der HF-Gehalt der Lösung betrug in jedem Fall ca. 1 Gew.%, bezogen auf die Gesamtlösung.

Bei den mit zusatzfreier HF-Lösung behandelten Scheiben lag die nach der Behandlung ermittelte Partikelzahl bei ca. 5000. Bei Zusatz von 0.02 Gew.% 15-Krone-5 verringerte sich die Partikelzahl auf 2498, während sie mit Hilfe einer 24-Krone-8 enthaltenden Lösung auf 1103 verringert werden konnte.

Beispiel 3:

Erneut wurden jeweils 5 schleierfrei polierte Siliciumscheiben mit in der in Beispiel 1 genannten Spezifikation und in der dort beschriebenen Weise in einem mit flußsäurehaltiger wässriger Lösung befüllten Tauchbad behandelt. Als Badflüssigkeit wurde bei der ersten Versuchsfahrt eine 1-gew.%ige wässrige HF-Lösung verwendet; bei der folgenden wurde ein Anteil von 0.9 Gew.% HCl als Komponente b) zugefügt, während bei der dritten als Komponente a) noch zusätzlich ein Anteil von 0.02 Gew.% Hydroxypropyl-α-Cyclodextrin in der Lösung vorlag. Bei allen drei Versuchsfahrten wies die Lösung eine Kontamination mit Eisen in Höhe von 0.1 Gew.-ppm, bezogen auf die Gesamtlösung, auf.

Die durch diesen Eisengehalt der Badflüssigkeit verursachte Kontamination der behandelten Scheiben wurde durch Messung der Diffusionslänge der Minoritätsladungsträger ermittelt. Die Messung wurde entsprechend dem im Tagungsbericht zum Spring Meeting der Electrochemical Society vom 15.-20. Mai 1988 in Atlanta (Georgia) auf S. 273 als Abstract 177 von G.Zoth und W. Bergholz mit dem Titel "Fast large area determination of Fe concentration in p-type silicon" beschriebenen Testverfahren durchgeführt. Dabei ergeben sich um so kürzere Diffusionslängen, je stärker die Scheiben mit Eisen kontaminiert sind.

Bei den in der ersten Versuchsfahrt behandelten Scheiben lag die Diffusionslänge bei 23 $\mu$m, was auf eine deutliche Kontamination mit dem in der Lösung vorhandenen Eisen hinwies. Bei Behandlung der Scheiben mit der zusätzlich die Komponente b) enthaltenden Lösung in der zweiten Versuchsreihe verringerte sich die Kontamination, und die Diffusionslänge stieg auf ca. 49 $\mu$m. Bei den in der dritten Versuchsreihe mit der die Komponenten a) und b) enthaltenden Lösung behandelten Scheiben ergab sich eine nochmalige erhebliche Verringerung der Kontamination, was sich an dem ausgezeichneten Wert von 216 $\mu$m für die Diffusionslänge der Minoritätsträger erkennen ließ.

## Patentansprüche

1. Verfahren zur naßchemischen Behandlung von Halbleiteroberflächen durch Einwirkung von flußsäurehaltigen wäßrigen Lösungen, dadurch gekennzeichnet, daß die eingesetzten Lösungen als zusätzliche Komponenten
a) zur Bildung von Einschlußverbindungen befähigte, Ringmoleküle bildende organische Verbindungen
b) das zu behandelnde Halbleitermaterial nicht oxidierende, einen pKs-Wert von weniger als 3.14 aufweisende Säuren,
einzeln oder in Kombination enthalten.

2. Verfahren nach Anspruch 1, dadurch gekennzeichnet, daß als Komponenten a) Cyclodextrine oder Kronenether ausgewählt werden.

3. Verfahren nach den Ansprüchen 1 oder 2, dadurch gekennzeichnet, daß aus 6 bis 8 D-Glucoseeinheiten bestehende Cyclodextrine ausgewählt werden.

4. Verfahren nach einem oder mehreren der Ansprüche 1 bis 3, dadurch gekennzeichnet, daß der Anteil der Komponente a), bezogen auf die Gesamtlösung, bis zu 0.1 Gew% beträgt.

5. Verfahren nach einem oder mehreren der Ansprüche 1 bis 4, dadurch gekennzeichnet, daß als Säuren Halogenwasserstoffsäuren, insbesondere Salzsäure, ausgewählt werden.

6. Verfahren nach einem oder mehreren der Ansprüche 1 bis 5, dadurch gekennzeichnet, daß der Anteil der Komponente b), bezogen auf die Gesamtlösung, bis zu 2 Gew.% beträgt.

7. Verfahren nach einem oder mehreren der Ansprüche 1 bis 6, dadurch gekennzeichnet, daß die Halbleiteroberflächen im Anschluß an die Einwirkung der wässrigen flußsäurehaltigen Lösung einer Bestrahlung mit UV-Licht unterzogen werden.

8. Wäßrige Lösung zur Durchführung des Verfahrens nach einem oder mehreren der Ansprüche 1 bis 7, enthaltend 0.08 bis 6 Gew.% Fluorwasserstoff sowie als Komponente a) bis zu 0.1 Gew.% Cyclodextrin.

9. Lösung nach Anspruch 8, zusätzlich als Komponente b) enthaltend bis zu 2 Gew.% Chlorwasserstoff.

10. Verwendung einer wässrigen flußsäurehaltigen Lösung, enthaltend 0.08 bis 6 Gew.% Fluorwasserstoff und bis zu 2 Gew.% Chlorwasserstoff, in einem Verfahren gemäß den Ansprüchen 1 bis 7.